# EUROPEAN PATENT SPECIFICATION

(11) **EP 2 925 112 B1**
(45) Date of publication and mention of the grant of the patent: **01.05.2019**
(21) Application number: 12888848.4
(22) Date of filing: 21.11.2012
(51) Int. Cl.: H05K 13/08, H05K 13/04

(54) **COMPONENT MOUNTING MACHINE**
MASCHINE ZUR MONTAGE VON KOMPONENTEN
MACHINE DE MONTAGE DE COMPOSANTS

(43) Date of publication of application: 30.09.2015
(73) Proprietor: FUJI Corporation, Chiryu Aichi (JP)
(72) Inventor: YAMAKAGE Yusuke, Chiryu Aichi (JP); IDO Takehiro, Chiryu Aichi (JP); YOSHINO Tomoharu, Chiryu Aichi (JP)
(74) Representative: Grünecker Patent- und Rechtsanwälte PartG mbB
(86) International application number: PCT/JP2012/080167
(87) International publication number: WO 2014/080474

(56) References cited:
- JP-A- H06 310 899
- JP-A- H07 263 897
- JP-A- S62 179 602
- JP-A- 2003 249 797
- JP-A- 2005 197 564
- JP-A- 2009 004 448
- JP-A- 2009 206 382
- US-A1- 2004 163 242

## Description

### Technical Field

The present invention relates to a component mounting machine which mounts a component on a substrate, and particularly, to an imaging device which is mounted on a component mounting machine.

### Background Art

As equipment which produces a substrate on which a plurality of components are mounted, a solder paste printing machine, a component mounting machine, a board detecting machine, or a reflow machine is employed, and in general, these machines are linked to each other by a board conveyance device and a board production line is built. Among these machines, the component mounting machine is provided with the board conveyance device, a component supply device, a component transfer device, and an imaging device, and shares work of mounting the components on the substrate. The imaging device takes an image from a lower part in a state where a suction nozzle of the component transfer device sucks the components, and is used for confirming a component mounting state.

Here, there is a case where position fiducial marks are disposed on a mounting head for allowing accurate ascertaining of a position of the moving suction nozzle on an imaging device side. By imaging both the position fiducial marks and the component which is sucked by the suction nozzle at the same time by the imaging device, the determination accuracy and the component mounting accuracy in a state where the component is sucked are improved. In other words, since an accurate position of the suction nozzle is ascertained, it is possible to determine a quality, for example, whether or not the suction nozzle excellently sucks a center portion of the component, or whether or not an end portion of the component is sucked and a state is unstable. Furthermore, by accurately determining the component suction state, the accuracy of the position when the component is mounted on the substrate is also improved. The above-described position fiducial mark is disposed considerably above a tip end portion of the suction nozzle, and does not interfere with the mounted component when the mounting head moves on the substrate.

In recent years, in order to shorten mounting tact time, there has been a tendency that the mounting head is made to move at a high speed, and exposure time when imaging is performed is also shortened. Furthermore, on-the-fly imaging for imaging while the suction nozzle moves above the imaging device without stopping has also become widespread, and the exposure time has further shortened. For this reason, it is necessary to open a diaphragm of a lens and to increase a light receiving amount of an image sensor, and as a result, a depth of field narrows . Accordingly, a range of an accurate focusing height narrows, and a case in which both the suction nozzle and the position fiducial mark that have different heights from each other cannot be clearly imaged is generated.

In order to support such a case, in a surface mounting machine (component mounting machine) of PTL 1, a focal position of a camera (imaging device) is positioned at substantially the same height as that of a mounting surface of a printed wiring board, the fiducial mark is positioned at a position which is higher than a component to be mounted of a moving head (mounting head), and a lens which adjusts the focal point of the camera to the fiducial mark is provided. Accordingly, it is described that it is possible to adjust the focal point of the camera to both the component to be mounted and the fiducial mark and to increase a moving speed of the moving head when on-the-fly imaging is performed.

### Citation List

### Patent Literature

PTL 1: JP-A-2005-197564
PTL 2: US 2004/163242 A1

### Summary of Invention

### Technical Problem

However, in the component mounting machine, when a type of the substrate to be produced is switched and the component to be mounted is changed, in order to shorten the mounting tact time after the change, there is a case where the mounting head is exchanged together with the suction nozzle. Here, disposition heights and installation positions of the position fiducial marks which are disposed on plural types of mounting heads do not necessarily match each other. In this case, in the technology of PTL 1, it is necessary to exchange a lens having a different focusing height and to change the position of the lens every time the mounting head is exchanged, and this causes complexity. Another example is known from PTL 2.

In addition, in a facing type component transfer device in which two mounting heads are disposed to be mutually facing, since the two mounting heads are mutually inverted by 180°, the installation position of the position fiducial mark is changed. In this case, when a camera (imaging device) which is common to the two mounting heads is provided, only one mounting head can be employed in the technology of PTL 1.

The present invention is to solve this problem of the above-described related art, and to provide a component mounting machine which images a position fiducial mark in which at least one of an installation position and an disposition height is different in plural types of mounting heads, and a component which is sucked by a suction nozzle at the same time, and which can contribute to improving the accuracy of a component mounting by obtaining a clear image.

### Solution to Problem

The invention is defined by the features of claim 1. Further embodiments are defined in the dependent claims.

The invention according to Claim 2 provides the component mounting machine in Claim 1, in which at least one of the plural types of mounting heads includes a plurality of suction nozzles which are arranged on a circumference, and in which the imaging device includes a plurality of sub-lenses which are respectively disposed at any of four corners of a rectangular visual field of the image sensor.

The invention according to Claim 3 provides the component mounting machine in Claim 1 or 2, in which the imaging device includes four sub-lenses which are respectively disposed at four corners of the rectangular visual field of the image sensor.

The invention according to Claim 4 provides the component mounting machine in any one of Claims 1 to 3, in which the plurality of sub-lenses have at least two focusing heights.

The invention according to Claim 5 provides the component mounting machine in any one of Claims 1 to 4, in which, in the sub-lens, an optical axis is offset between an incidence side and a passing-through side.

The invention according to Claim 6 provides the component mounting machine in Claim 5, in which, the sub-lens is disposed between the mounting head and the main lens, and the optical axis is offset towards to an outer edge side of the main lens at the passing-through side which faces the main lens from the sub-lens when considering the incidence side which faces the sub-lens from the mounting head as a reference.

### Advantageous Effects of Invention

In the invention of the component mounting machine according to Claim 1, by selectively using the plurality of sub-lenses, the imaging device can match the focusing heights to each of the position fiducial marks which are disposed on the plural types of mounting heads. For this reason, it is possible to obtain a clear image by performing imaging with respect to the position fiducial mark through the sub-lens and the main lens, and performing imaging with respect to the component only through the main lens, simultaneously. In addition, since it is possible to simultaneously and clearly image the position fiducial mark and the component sucked by the suction nozzle, it is possible to improve the accuracy of determination of a component suction state of the suction nozzle, and to contribute to improving the position accuracy when mounting the component on the substrate.

In the invention according to Claim 2, since at least one of the plural types of mounting heads includes the plurality of suction nozzles which are arranged on the circumference, four corners of the rectangular visual field of the image sensor are not used in imaging the component. The imaging device includes the sub-lenses at these four corners, images the position fiducial mark by effectively using the visual field of the image sensor, and can simultaneously image both the position fiducial mark and the component.

In the invention according to Claim 3, the imaging device includes four sub-lenses which are disposed at four corners of the rectangular visual field of the image sensor. Therefore, when there are four or less installation positions of the position fiducial marks of the plural types of mounting heads, it is possible to obtain a clear image without troublesome effort to exchange the sub-lens. Specifically, for example, even when two mounting heads are disposed to be inverted by 180° in the facing type component transfer device, and the installation positions of the position fiducial marks are different, it is possible to have a configuration in which exchanging the sub-lens is not necessary.

In the invention according to Claim 4, the plurality of sub-lenses include at least two focusing heights. Therefore, even when the disposition heights of the position fiducial marks of the plural types of mounting heads are different, it is possible to obtain a clear image by using the plurality of sub-lenses for different purposes.

In the invention according to Claim 5, in the sub-lens, the optical axes are offset on the incidence side and on the passing-through side. Therefore, the image of an object which is imaged through the sub-lens and the main lens is shifted in position in the visual field of the image sensor. Accordingly, it is possible to expand a setting range of the installation position of the position fiducial mark of the mounting head.

In the invention according to Claim 6 the sub-lens is disposed between the mounting head and the main lens, and the optical axes are offset to an outer edge side of the main lens on the passing-through side when considering the incidence side which faces the sub-lens from the mounting head as a reference. Therefore, the image of the object which is imaged through the sub-lens and the main lens is shifted on the outer edge side of the main lens in the visual field of the image sensor. Furthermore, an unclear visual field range which is generated by interference of light passing through the sub-lens and the main lens, and light passing only through the main lens, that is, so-called ghosting is also shifted to the outer edge side of the main lens. Therefore, it is possible to reduce an influence of ghosting generated by providing the sub-lens such that it does not encroach on the visual field of imaging the component, and to ensure a wide visual field of imaging the component near the center of the main lens.

### Brief Description of Drawings

Fig. 1 is a perspective view illustrating the entire structure of a component mounting machine of a first embodiment.
Fig. 2 is a schematic side view illustrating a configuration example of an imaging device and a mounting head.
Fig. 3 is a plan view when the imaging device is viewed from above.
Fig. 4 is a plan view of the imaging device illustrating a ghost range which is generated in a visual field of imaging, in the first embodiment.
Fig. 5 is a side view illustrating properties of a sub-lens which is used in a second embodiment.
Fig. 6 is a partial plan view of the imaging device illustrating operations and effects of a component mounting machine of the second embodiment.
Fig. 7 is a side view illustrating properties and disposition of the sub-lens which are used in an application example of the second embodiment.

### Description of Embodiments

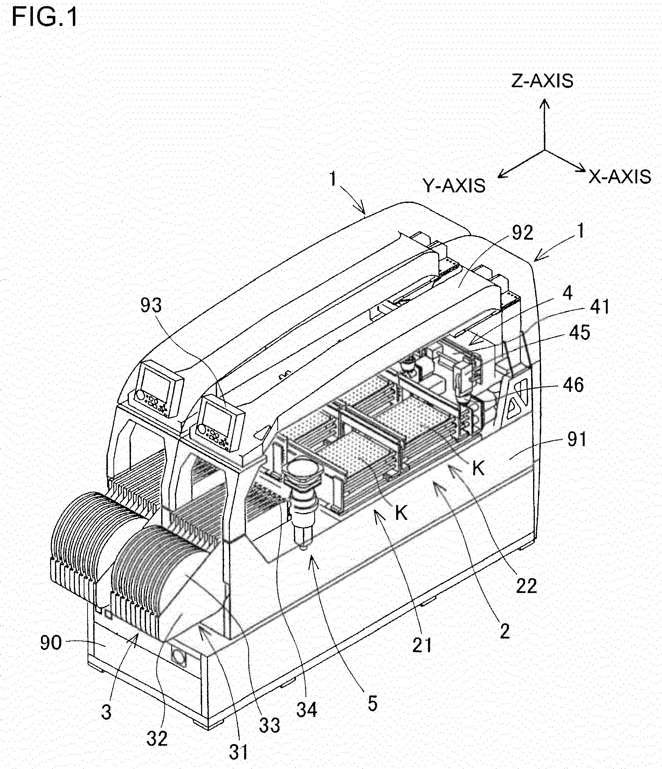

A component mounting machine 1 according to a first embodiment of the present invention will be described with reference to Figs. 1 to 3. Fig. 1 is a perspective view illustrating the entire structure of the component mounting machine 1 of the first embodiment. In Fig. 1, two component mounting machines 1 which are aligned in parallel on a common base 90 are illustrated. Hereinafter, a description will be given of one component mounting machine. The component mounting machine 1 has a configuration in which a board conveyance device 2, a component supply device 3, a component transfer device 4, an imaging device 5, and a control computer which is not illustrated are assembled to an apparatus stand 91 (reference numeral is given only to the component mounting machine 1 on a front right side). As illustrated in XYZ coordinate axes at an upper right part of Fig. 1, a horizontal width direction (a direction which is oriented toward a lower right part from an upper left part of a paper surface of Fig. 1) of the component mounting machine 1 is set to be an X-axis direction, a horizontal longitudinal direction (a direction which is oriented toward a lower left part from the upper right part of the paper surface of Fig. 1) of the component mounting machine 1 is set to be a Y-axis direction, and a vertical height direction is set to be a Z-axis direction.

The board conveyance device 2 is provided around an intermediate part of the component mounting machine 1 in a longitudinal direction. The board conveyance device 2 is a so-called double conveyer type device in which a first conveyance device 21 and a second conveyance device 22 are aligned in parallel. The first and the second conveyance devices 21 and 22 convey in, position, and convey out two substrates K in the X-axis direction by conveying the two substrates K in parallel. The first and the second conveyance devices 21 and 22 respectively include a pair of conveyor rails (reference numeral thereof is omitted) which are provided parallel to and separated from each other on the apparatus stand 91 and parallel to the X-axis direction. Each conveyor rail forms a conveyance path, and a conveyor belt (not illustrated) is constructed to be rotatable. The conveyor belt conveys a substrate K which is loaded by the rotation. In addition, each of the first and the second conveyance devices 21 and 22 includes a board holding device (not illustrated) which positions and holds the substrate K conveyed to a component mounting position by pushing up the substrate K from the apparatus stand 91 side.

The component supply device 3 is a feeder type device, and is provided in a front portion (front left side of Fig. 1) of the component mounting machine 1 in the longitudinal direction. The component supply device 3 has a configuration in which a plurality of cassette type feeders 31 are aligned in parallel in the X-axis direction on the apparatus stand 91. Each cassette type feeder 31 includes a main body 32 which is attached to be attachable to and detachable from the apparatus stand 91, a supply reel 33 which is mounted to be rotatable or attachable and detachable on a rear portion (front side of the component mounting machine 1) of the main body 32, and a component supply section 34 which is provided at a tip end (near the center of the component mounting machine 1) of the main body 32. The supply reel 33 is a medium which supplies the component, and a carrier tape (not illustrated) which holds a plurality of components with a certain interval therebetween is wound around the supply reel 33. A tip end of the carrier tape is drawn out to the component supply section 34, and different components are supplied to every carrier tape.

The component transfer device 4 is a so-called XY robot type device which can move in the X-axis direction and in the Y-axis direction. The component transfer device 4 is installed across an upper part of the component supply device 3 of the front portion of the component mounting machine 1 from a rear portion (far right side of Fig. 1) of the component mounting machine 1 in the longitudinal direction. The component transfer device 4 is configured of a head driving mechanism 41 (most of the head driving mechanism 41 is omitted in Fig. 1) and a mounting head 45. The head driving mechanism 41 drives the mounting head 45 in the X-axis direction and in the Y-axis direction.

A nozzle holder 46 is provided below the mounting head 45. The nozzle holder 46 downwardly holds a plurality of suction nozzles which suck and mount the component by using a negative pressure. The mounting head 45 includes an R-axis rotation driving mechanism (not illustrated) which rotates and drives the nozzle holder 46 around a Z axis. Furthermore, the mounting head 45 includes a Z-axis driving mechanism (not illustrated) which makes a selected suction nozzle perform an extension movement and a retraction movement in the Z-axis direction, and a θ-axis rotation driving mechanism (not illustrated) which rotates and drives the selected suction nozzle around the Z axis. These driving mechanisms use a servo motor as a driving source, and are driven by torque which is output from the servo motor.

The head driving mechanism 41 is configured to exchange and hold plural types of mounting heads 45 together with the nozzle holder 46 and the suction nozzle. In each of the plural types of mounting heads 45, position fiducial marks are disposed. Installation positions and disposition heights of the position fiducial marks in the mounting heads 45 do not necessarily match each other.

The imaging device 5 is a device which includes an image sensor 51 and a main lens 52, and takes an image in a state when the suction nozzle sucks the component from below. The imaging device 5 is installed upwardly on the apparatus stand 91 in the vicinity of the component supply section 34 of the component supply device 3. A detailed configuration example of the imaging device 5 will be described later.

The control computer which is not illustrated is connected to the board conveyance device 2, the component supply device 3, the component transfer device 4, and the imaging device 5, by a communication cable. The control computer performs computation or determination by acquiring necessary information from each device 2 to 5, and controls the movements of each device 2 to 5 by generating appropriate commands. In order that an operator confirms information output from the control computer, and further, performs necessary operations or settings, a display operating device 93 is installed in a front upper portion of a cover 92 of the upper portion.

In the component mounting machine 1 of the first embodiment, a series of operations from suction of the components to mounting is performed as follows. In other words, first, the head driving mechanism 41 of the component transfer device 4 moves the mounting head 45 to a position above the component supply section 34 of the cassette type feeder 31 to which the mounted component is supplied. Next, the Z-axis driving mechanism is operated, and the suction nozzle performs the extension movement downward. The suction nozzle sucks the component in a tip end portion at the lower part by using a negative pressure. Next, the head driving mechanism 41 moves the mounting head 45 to a position above the imaging device 5. The imaging device 5 images the state where the suction nozzle sucks the component from below, and confirms a component mounting state. Next, the head driving mechanism 41 moves the mounting head 45 to a position above the positioned substrate K. Next, the Z-axis driving mechanism is operated, the suction nozzle performs the extension movement downward, and the component is mounted by being abutted against the substrate K.

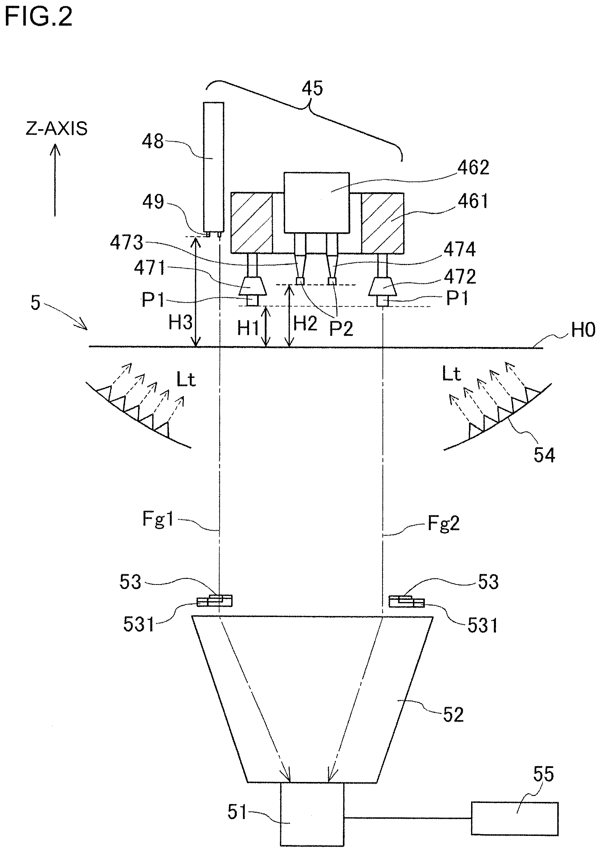

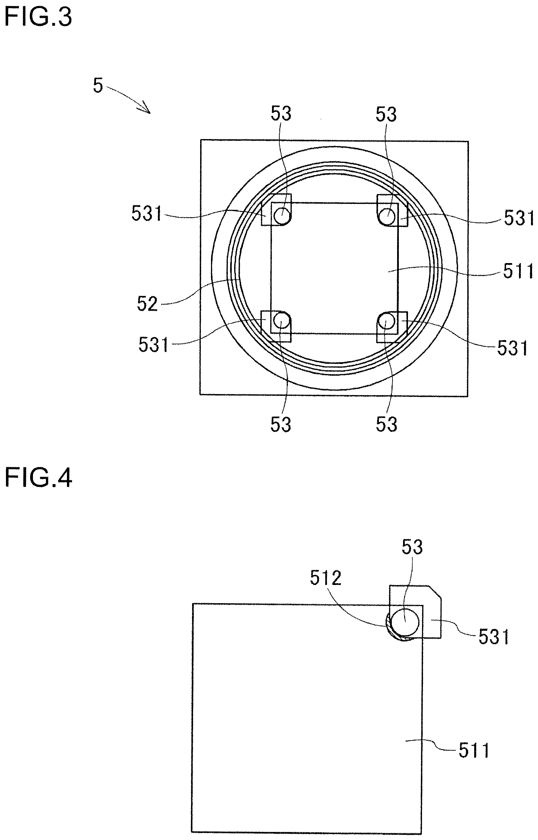

Next, a detailed configuration example and an imaging operation of the imaging device 5 and the mounting head 45 will be described. Fig. 2 is a schematic side view illustrating the configuration example of the imaging device 5 and the mounting head 45. In addition, Fig. 3 is a plan view when the imaging device 5 is viewed from above.

As illustrated in Fig. 2, the mounting head 45 includes two nozzle holders 461 and 462, and an image reference section 48. The first nozzle holder 461 has a substantially annular shape. The first nozzle holder 461 includes a plurality of large-sized suction nozzles 471 and 472 which extend downward from a lower surface thereof. The large-sized suction nozzles 471 and 472 are arranged with an equivalent intervals therebetween on the circumference. The second nozzle holder 462 has a substantially columnar shape, and is installed inside the annular shape of the first nozzle holder 461. The second nozzle holder 462 also includes a plurality of small-sized suction nozzles 473 and 474 which extend downward from a lower surface thereof. The small-sized suction nozzles 473 and 474 are also arranged with an equivalent interval therebetween on the circumference. Each of the number of the large-sized suction nozzles 471 and 472 and the small-sized suction nozzles 473 and 474, can be 4, 6, 8, or 12.

A component P1 which can be sucked by the large-sized suction nozzles 471 and 472 is relatively large-sized compared to a component P2 which can be sucked by the small-sized suction nozzles 473 and 474. Each of the suction nozzles 471 to 474 performs the extension movement downward from the nozzle holders 461 and 462, but a predetermined height is maintained above the imaging device 5. With respect to a height reference surface H0 of the imaging device 5, a height H1 of the component P1 which is sucked by the large-sized suction nozzles 471 and 472 is low, and a height H2 of the component P2 which is sucked by the small-sized suction nozzles 473 and 474 is high.

The image reference section 48 is a member which serves as a reference for a position of the mounting head 45. On a lower surface of the image reference section 48, four position fiducial marks 49 having a small circular shape are disposed to be disposed in a square shape. Not being limited to this, a degree of freedom is allowed in the number, the shape, and the disposition of the position fiducial marks 49. The installation position of the image reference section 48 on the mounting head 45, or a disposition height H3 from the height reference surface H0 of the position fiducial mark 49 changes depending on the type of the mounting head 45. As illustrated in Fig. 2, the disposition height H3 of the position fiducial mark 49 is considerably higher than the height H1 and height H2 of the components P1 and P2. Therefore, when the mounting head 45 moves on the substrate K, the image reference section 48 does not interfere with the mounted component.

The imaging device 5 is configured of the image sensor 51, the main lens 52, four sub-lenses 53, a light source section 54, an image processing section 55 and the like. In addition, the image processing section 55 can be also used as the control computer.

The image sensor 51 is provided below the imaging device 5, and a visual field 511 thereof faces upward. The image sensor 51 is configured so that a plurality of light receiving elements are two-dimensionally disposed, and the rectangular visual field 511 is provided. As the light receiving element, it is possible to use a charge-coupled device (CCD) or a complementary metal-oxide film semiconductor (CMOS), but the invention is not limited thereto.

The main lens 52 is provided to be in contact with an upper side of the image sensor 51, and covers the entire range of the visual field 511 of the image sensor 51. As the main lens 52, it is possible to use a known condensing lens. In addition, the main lens 52 can be configured by combining a plurality of convex lenses and concave lenses. Furthermore, it is possible to use an aspherical lens in which spherical aberration is reduced, or a low-dispersion lens in which dispersion of light is reduced and chromatic aberration is reduced, as the main lens 52. A focal length of the main lens 52 is set so that the focusing height substantially matches the component P1 and the component P2. In addition, the main lens 52 may be provided at an interval from the image sensor 51.

Four sub-lenses 53 are significantly smaller than the main lens 52. Four sub-lenses 53 are installed at a slight interval on an upper side of the main lens 52 by using a fitting seat 531. As illustrated in Fig. 3, each fitting seat 531 is disposed across the inside of each of four corners from outside the four corners of the rectangular visual field 511 of the image sensor 51. Four sub-lenses 53 are disposed inside four corners of the rectangular visual field 511 of the image sensor 51, and cover a part of the visual field 511 of the image sensor 51. In addition, any one of the sub-lenses 53 is disposed to be positioned right below the position fiducial mark 49. The focal length of the sub-lens 53 which is positioned right below the position fiducial mark 49 is set so that the focusing height which is viewed through the main lens 52 and the sub-lens 53 from the image sensor 51 substantially matches the position fiducial mark 49.

Meanwhile, the focal lengths of the other three sub-lenses 53 are set so that the focusing heights become different from each other. Not being limited thereto, the focal lengths may match each other with some of the total four sub-lenses 53. Furthermore, by matching the installation positions and the focusing heights of the other three sub-lenses 53, the position fiducial mark of another mounting head to be exchanged is set. In other words, the total four sub-lenses 53 have different installation positions and the focusing heights from each other, and the plurality of mounting heads can be exchanged corresponding to each of the sub-lenses 53.

As illustrated by a dash-line arrow Lt in Fig. 2, the light source section 54 is a portion which irradiates an obj ect, such as the components P1 and P2 or the position fiducial mark 49 with the light obliquely from below. The light source section 54 is installed at a height between the sub-lens 53 and the height reference surface H0. For example, the light source section 54 can be configured so that a plurality of light-emitting diodes (LED) are arrayed on a curved surface. A wavelength (color) or intensity of the light which is emitted by the light source section 54 is not limited. In addition, although not illustrated in Fig. 2, the object may be irradiated with the light from immediately below by providing a direct light source and a half-silvered mirror, and the object may be superimposed on the light obliquely from below. On the height reference surface H0, transparent glass (reference numeral thereof is omitted) is provided to extend.

The image processing section 55 is connected to the image sensor 51, receives image data from the image sensor 51, and performs a predetermined image processing. By performing the image processing, the image processing section 55 can accurately ascertain the positions of a position fiducial mark 481 and each of the suction nozzles 471 to 474, and can determine whether or not the suction state of the components P1 and P2 is excellent.

Next, the operations and the effects of the component mounting machine 1 of the first embodiment which is configured as described above will be described. When the mounting head 45 moves to a position above the imaging device 5, the position fiducial mark 49, all of the suction nozzles 471 to 474, and the components P1 and P2 enter the visual field 511 of the image sensor 51. The image of the position fiducial mark 49 is imaged by the image sensor 51 through any of the sub-lens 53 and the main lens 52 as illustrated by a one-dot chain line broken arrow line Fg1 in Fig. 2. Meanwhile, the images of the components P1 and P2 which are sucked by the suction nozzles 471 to 474 are imaged by the image sensor 51 only through the main lens 52 as illustrated by a one-dot chain line broken arrow line Fg2. For this reason, the focusing heights separately match both the position fiducial mark 49 and the components P1 and P2. Therefore, the imaging device 5 can obtain a clear image by simultaneously imaging both the position fiducial mark 49 and the components P1 and P2.

In addition, since the imaging device 5 can simultaneously and clearly image the position fiducial mark 49 and the components P1 and P2, the accuracy of determination of a component suction state of the suction nozzles 471 to 474 is improved. Furthermore, it is possible to contribute to improving the accuracy of the position when mounting the components P1 and P2 on the substrate K.

In addition, the imaging device 5 includes four sub-lenses which are disposed at four corners of the rectangular visual field 511 of the image sensor 51. For this reason, the imaging device 5 can use the center of the rectangular visual field 511 in imaging the components P1 and P2, can use four corners of the visual field 511 in imaging the position fiducial mark 49, and can effectively use the entire visual field 511. Furthermore, the focusing heights of four sub-lenses 53 are different from each other. Therefore, if various combinations of the installation positions and the disposition height H3 of the position fiducial mark 49 of the mounting head 45 are four or less cases, it is possible to obtain a clear image corresponding to the fact that troublesome effort to exchange the sub-lens 53 is not necessary.

For example, when the component mounting machine 1 is provided with the facing type component transfer device, since two mounting heads are disposed to be mutually inverted by 180° to each other, the installation positions of the position fiducial marks are different even when the same mounting heads are used. According to the first embodiment, it is possible to support this case with two sub-lenses 53 in which the installation positions are different from each other and the focal lengths match each other. In addition, when the number of combinations of the installation positions and the disposition height H3 of the position fiducial mark 49 is five or more cases, it is easy to support a case where the installation positions and the disposition heights of the mounting heads to be added later are different since only the relay-lens 53 may be exchanged.

Furthermore, in the imaging device 5, since focusing heights respectively match the position fiducial mark 49 and the components P1 and P2, it is possible to shorten the exposure time. Therefore, it is possible to perform on-the-fly imaging while moving the mounting head 45 at a high speed, and to shorten mounting tact time.

Meanwhile, when the sub-lens 53 is provided while matching to the disposition height H3 of the position fiducial mark 49, the focusing height is changed compared to the configuration in which only the main lens 52 is provided. Accordingly, the imaging device 5 cannot clearly image the component in the range of the visual field which corresponds to a part immediately above the sub-lens 53. In addition, the imaging device 5 cannot clearly image the component even in the range of the visual field which corresponds to a part immediately above the fitting seat 531. Furthermore, an unclear visual field range which is generated by interference of light passing through the sub-lens 53 and the main lens 52, and light passing only through the main lens 52, that is, so-called ghosting is generated. The imaging device 5 cannot clearly image the component in a ghost range.

Fig. 4 is a plan view of the imaging device 5 illustrating a ghost range 512 which is generated in the visual field 511 of imaging, in the first embodiment. In the first embodiment, in the sub-lens 53, optical axes match on an incidence side and on a passing-through side. In this case, as illustrated in Fig. 4, the ghost range 512 is generated near the center on the periphery of the sub-lens 53 in the visual field 511 of the image sensor 51. As illustrated by hatching in Fig. 4, a shape of the ghost range 512 becomes a shape of an arc having a substantially constant width and continues to a position at which there is blocking by the fitting seat 531. In this manner, when the sub-lens 53 is provided, the arc-shaped ghost range 512 is generated. In the configuration of the first embodiment, only the ghost range 512 encroaches on the visual field of imaging the component.

Meanwhile, in the mounting head or the like which includes a large-sized nozzle holder, restriction of the installation position of the position fiducial mark is strict. Accordingly, a case where the position fiducial mark cannot be disposed in any manner in the visual field through the main lens 52 and the sub-lens 53 of the imaging device 5 is generated. In this case, in the configuration of the first embodiment, it is not possible to image the position fiducial mark.

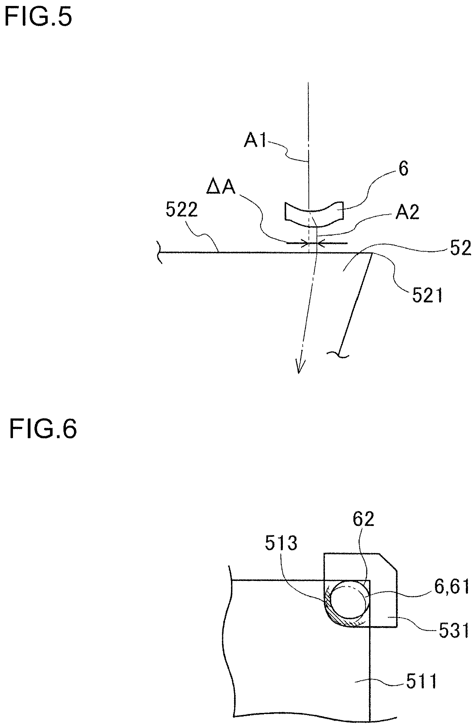

As a unit that solves a problem of encroachment on the imaging visual field by the above-described ghost range 512 or a problem of restriction of the installation position of the position fiducial mark, it is possible to use the component mounting machine of a second embodiment. In the component mounting machine of the second embodiment, properties of a sub-lens 6 are different from those in the first embodiment, and the configurations of other parts are the same as those in the first embodiment. Fig. 5 is a side view illustrating the properties of the sub-lens 6 which is used in the second embodiment.

As illustrated in Fig. 5, in the sub-lens 6 which is used in the second embodiment, the optical axis is offset between the incidence side and the passing-through side. Specifically, when an optical axis A1 on the incidence side which faces the sub-lens 6 from the mounting head 45 is set to be a reference, an optical axis A2 on the passing-through side which faces the main lens 52 from the sub-lens 6 is offset only by a difference in an optical axis ΔA to an outer edge 521 side of the main lens 52.

Next, the operations and the effects of the component mounting machine of the second embodiment will be described. Fig. 6 is a partial plan view of the imaging device illustrating the operations and the effects of the component mounting machine of the second embodiment. In Fig. 5, the light which is incident on an arbitrary position of the sub-lens 6 from the object is deviated to the outer edge 521 side of the main lens 52 only by the difference in an optical axis ΔA at a point in time when passing through the sub-lens 6, and after this, is incident on the main lens 52. Therefore, as illustrated in Fig. 6, an image 61 (illustrated by a two-dot chain line) of the object which is incident on the sub-lens 6 becomes an image 62 (illustrated by a solid line) which is shifted in position to the outer edge 521 of the main lens 52 only by the difference in an optical axis ΔA when passing through the sub-lens 6.

The image sensor 51 images the position-shifted image 62. In addition, the image processing section 55 stores information regarding a position shift amount which corresponds to the difference in an optical axis ΔA and a region of the position-shifted image 62 in advance. Therefore, the image processing section 55 can perform correction-computation only with the difference in an optical axis ΔA with respect to the position fiducial mark included in the position-shifted image 62, and can obtain the correct position of the position fiducial mark.

Similarly to the images 61 and 62, the ghost range 512 of Fig. 4 is also shifted in position as illustrated in Fig. 6. In other words, the ghost range 512 is imaged to be a ghost range 513 which is shifted in position to the outer edge side 521 of the main lens 52 only by the difference in an optical axis ΔA. Most of the position-shifted ghost range 513 overlaps at a position which corresponds to the fitting seat 531. In addition, the ghost range 512 illustrated in Fig. 4 disappears, and it is possible to clearly image the component. In other words, it is possible to reduce an influence of the ghost range 512 such that it does not encroach on the visual field of imaging the component, and to ensure a wide visual field of imaging the component near a center 522 of the main lens 52.

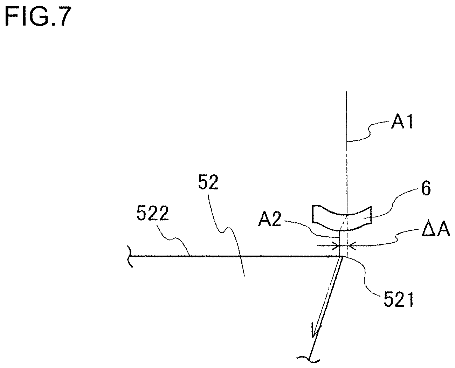

In addition, by applying the second embodiment, the sub-lens 6 may be installed as illustrated in Fig. 7. Fig. 7 is a side view illustrating properties and disposition of the sub-lens 6 which is used in an application example of the second embodiment. In the application example, when an offset direction of the sub-lens 6 is reversed, and the optical axis A1 on the incidence side is set to be a reference, the optical axis A2 on the passing-through side is offset only by the difference in an optical axis ΔA to the side near the center 522 of the main lens 52. Furthermore, the center of the sub-lens 6 is disposed in the vicinity of the outer edge 521 of the main lens 52, or, on a further outside than the outer edge 521.

In a configuration of the above-described application example, when passing through the sub-lens 6, the image of the object becomes an image which is shifted in position only by the difference in an optical axis ΔA to the side near the center 522 of the main lens 52. Therefore, even when the position fiducial mark is disposed on a further outside than the outer edge 521 of the main lens 52, it is possible to perform imaging by the image sensor 51. In other words, compared to the first embodiment, it is possible to widen a setting range of the installation position of the position fiducial mark of the mounting head.

In addition, in the first and the second embodiments, the sub-lenses 53 and 6 are disposed between the mounting head 45 and the main lens 52, but the invention is not limited thereto. For example, the sub-lenses 53 and 6 may be disposed between the main lens 52 and the image sensor 51, or the sub-lenses 53 and 6 may be disposed between the plurality of lenses that constitute the main lens 52. In addition, in a state where the sub-lens 6 is offset in the second embodiment, the effects are generated even when only one sub-lens 6 is provided. In addition to the described configuration, the present invention can be applied or modified as defined by claim 1 and the dependent claims.

### Reference Signs List

1: Component mounting machine
2: Board conveyance device 3: Component supply device
4: Component transfer device
41: Head driving mechanism 45: Mounting head
46: Nozzle holder
461: First nozzle holder 462: Second nozzle holder
471, 472: Large-sized suction nozzle
473, 474: Small-sized suction nozzle
48: Image reference section 49: Position fiducial mark
5: Imaging device
51: image sensor 511: Visual field
512: Ghost range 513: Position-shifted ghost range
52: Main lens 521: Outer edge 522: Center
53: Sub-lens 531: Fitting seat
54: Light source section 55: Image processing section
6: Sub-lens (second embodiment)
K: substrate P1, P2: Component
A1, A2: Optical axis ΔA: Difference in an optical axis

## Claims

1. A component mounting machine (1), comprising:
a component supply device (3) which is configured to supply plural types of components (P1, P2);
a component transfer device (4) which includes a mounting head (45) having a suction nozzle (471, 472, 473, 474) for sucking the components (P1, P2) from the component supply device (3) and mounting the components (P1, P2) on a positioned substrate (K), and a head driving mechanism (41) which is configured to move the mounting head (45) in a horizontal plane; and
an imaging device (5) which includes an image sensor (51) and a main lens (52), and is configured to take an image in a state where the suction nozzle (471, 472, 473, 474) sucks the component (P1, P2) from below, **characterized in that** the imaging device (5) includes a plurality of sub-lenses (53, 6) that are disposed between the mounting head (45) and the image sensor (51),
and is configured to take an image of a position fiducial mark (49) that is respectively disposed in plural types of mounting heads (45) by the image sensor (51) through a sub-lens (53, 6) out of the plurality of sub-lenses (53, 6) and the main lens (52) the position fiducial mark (49) is respectively disposed in the plural types of mounting heads (45), wherein at least one of an installation position and a disposition height (H3) of the fiducial position mark (49) is different depending on the type of the mounting head (45).

2. The component mounting machine (1) according to Claim 1,
wherein at least one of the plural types of mounting heads (45) includes a plurality of suction nozzles (471, 472, 473, 474) which are arranged on a circumference; and wherein the imaging device (5) includes a plurality of sub-lenses (53, 6) which are respectively disposed at any of four corners of a rectangular visual field (511) of the image sensor (51).

3. The component mounting machine (1) according to Claim 1 or 2,
wherein the imaging device (5) includes four sub-lenses (53, 6) which are respectively disposed at four corners of the rectangular visual field (511) of the image sensor (51).

4. The component mounting machine according to any one of Claims 1 to 3,
wherein the plurality of sub-lenses have at least two focusing heights.

5. The component mounting machine (1) according to any one of Claims 1 to 4,
wherein, in the sub-lens (6), an optical axis (A1, A2) is offset between an incidence side and a passing-through side.

6. The component mounting machine (1) according to Claim 5,
wherein the sub-lens is (6) disposed between the mounting head (45) and the main lens (52), and the optical axis (A2) is offset towards to an outer edge side of the main lens (52) at the passing-through side which faces the main lens (52) from the sub-lens (6) when considering the incidence side which faces the sub-lens (6) from the mounting head (45) as a reference.

## Patentansprüche

1. Komponenten-Montagemaschine (1), umfassend:
eine Komponentenzufuhrvorrichtung (3), die konfiguriert ist, mehrere Arten von Komponenten (P1, P2) zuzuführen;
eine Komponenten-Transfervorrichtung (4), die einen Montagekopf (45) umfasst, der eine Saugdüse (471, 472, 473, 474) zum Ansaugen der Komponenten (P1, P2) von der Komponenten-Zuführvorrichtung (3) und zum Montieren der Komponenten (P1, P2) auf einem positionierten Substrat (K) aufweist, und einen Kopf-Antriebsmechanismus (41), der konfiguriert ist, den Montagekopf (45) in einer horizontalen Ebene zu bewegen; und
eine Bilderfassungsvorrichtung (5), die einen Bildsensor (51) und eine Hauptlinse (52) umfasst und konfiguriert ist, ein Bild von unten in einem Zustand aufzunehmen, in dem die Saugdüse (471, 472, 473, 474) die Komponente (P1, P2) ansaugt, **dadurch gekennzeichnet, dass**
die Bilderfassungsvorrichtung (5) eine Vielzahl von Unterlinsen (53, 6) umfasst, die zwischen dem Montagekopf (45) und dem Bildsensor (51) angeordnet sind,
und konfiguriert ist, ein Bild einer Positionsreferenzmarke (49), die jeweils in mehreren Arten von Montageköpfen (45) angeordnet ist, mit dem Bildsensor (51) durch eine Unterlinse (53, 6) aus der Vielzahl der Unterlinsen (53, 6) und der Hauptlinse (52) aufzunehmen, wobei die Positionsreferenzmarke (49) jeweils in den mehreren Arten von Montageköpfen (45) angeordnet ist, wobei
sich mindestens eine von einer Installationsposition und einer Anordnungshöhe (H3) der Positionsreferenzmarke (49) abhängig von der Art des Montagekopfes (45) unterscheidet.

2. Die Komponenten-Montagemaschine (1) gemäß Anspruch 1,
wobei mindestens einer von den mehreren Arten von Montageköpfen (45) eine Vielzahl von Saugdüsen (471, 472, 473, 474) umfasst, die auf einem Umfang angeordnet sind; und
wobei die Bilderfassungsvorrichtung (5) eine Vielzahl von Unterlinsen (53, 6) umfasst, die jeweils an einer beliebigen von vier Ecken eines rechteckigen Sichtfeldes (511) des Bildsensors (51) angeordnet sind.

3. Die Komponenten-Montagemaschine (1) gemäß Anspruch 1 oder 2,
wobei die Bildgebungsvorrichtung (5) vier Unterlinsen (53, 6) umfasst, die jeweils an vier Ecken des rechteckigen Sichtfeldes (511) des Bildsensors (51) angeordnet sind.

4. Die Komponenten-Montagemaschine (1) gemäß einem der Ansprüche 1 bis 3,
wobei die Vielzahl von Unterlinsen mindestens zwei Fokushöhen aufweisen.

5. Die Komponenten-Montagemaschine (1) gemäß einem der Ansprüche 1 bis 4,
wobei bei der Unterlinse (6) eine optische Achse (A1, A2) zwischen einer Einfalls-Seite und einer Durchgangs-Seite versetzt ist.

6. Die Komponenten-Montagemaschine (1) gemäß Anspruch 5,
wobei die Unterlinse (6) zwischen dem Montagekopf (45) und der Hauptlinse (52) angeordnet ist und die optische Achse (A2) in Richtung einer Außenkanten-Seite der Hauptlinse (52) an der Durchgangs-Seite versetzt ist, welche der Hauptlinse (52) von der Unterlinse (6) aus zugewandt ist, wenn die Einfalls-Seite, welche der Unterlinse (6) von dem Montagekopf (45) aus zugewandt ist, als Referenz betrachtet wird.

## Revendications

1. Machine de montage de composants (1) comprenant :
un dispositif d'alimentation en composants (3) qui est configuré pour alimenter plusieurs types de composants (P1, P2) ;
un dispositif de transfert de composants (4) qui comprend une tête de montage (45) ayant une buse d'aspiration (471, 472, 473, 474) pour aspirer les composants (P1, P2) depuis le dispositif d'alimentation en composants (3) et monter les composants (P1, P2) sur un substrat positionné (K), et un mécanisme d'entraînement de tête (41) qui est configuré pour déplacer la tête de montage (45) dans un plan horizontal ; et
un dispositif d'imagerie (5) qui comprend un capteur d'image (51) et une lentille principale (52), et qui est configuré pour prendre une image d'un état où la buse d'aspiration (471, 472, 473, 474) aspire le composant (P1, P2) de dessous, **caractérisée en ce que**
le dispositif d'imagerie (5) comprend une pluralité de sous-lentilles (53, 6) qui sont disposées entre la tête de montage (45) et le capteur d'image (51),
et est configuré pour prendre une image d'une marque de repère de position (49) qui est respectivement disposée dans plusieurs types de têtes de montage (45) par le capteur d'image (51) à travers une lentille (53, 6) parmi la pluralité de sous-lentilles (53, 6) et la lentille principale (52), la marque de repère de position (49) est disposée respectivement dans les plusieurs types de têtes de montage (45), dans laquelle au moins l'une parmi une position d'installation et une hauteur de disposition (H3) de la marque de repère de position (49) est différente en fonction du type de la tête de montage (45).

2. Machine de montage de composants (1) selon la revendication 1,
dans laquelle au moins l'un des plusieurs types de têtes de montage (45) comprend une pluralité de buses d'aspiration (471, 472, 473, 474) qui sont agencées sur une circonférence ; et
dans laquelle le dispositif d'imagerie (5) comprend une pluralité de sous-lentilles (53, 6) qui sont respectivement disposées à l'un quelconque parmi quatre coins d'un champ visuel rectangulaire (511) du capteur d'image (51).

3. Machine de montage de composants (1) selon la revendication 1 ou 2,
dans laquelle le dispositif d'imagerie (5) comprend quatre sous-lentilles (53, 6) qui sont respectivement disposées à quatre coins du champ visuel rectangulaire (511) du capteur d'image (51).

4. Machine de montage de composants selon l'une quelconque des revendications 1 à 3,
dans laquelle la pluralité de sous-lentilles ont au moins deux hauteurs de focalisation.

5. Machine de montage de composants (1) selon l'une quelconque des revendications 1 à 4,
dans laquelle, dans la sous-lentille (6), un axe optique (A1, A2) est décalé entre un côté d'incidence et un côté de passage traversant.

6. Machine de montage de composants (1) selon la revendication 5,
dans laquelle la sous-lentille (6) est disposée entre la tête de montage (45) et la lentille principale (52), et l'axe optique (A2) est décalé vers un côté de bord extérieur de la lentille principale (52) au niveau du côté de passage traversant qui fait face à la lentille principale (52) depuis la sous-lentille (6) lorsque le côté d'incidence qui fait face à la sous-lentille (6) depuis la tête de montage (45) est considéré être une référence.
